(19) Europäisches Patentamt
European Patent Office
Office européen des brevets

(11) **EP 1 916 704 A1**

(12) **EUROPEAN PATENT APPLICATION**
published in accordance with Art. 153(4) EPC

(43) Date of publication:
**30.04.2008 Bulletin 2008/18**

(51) Int Cl.:
*H01L 21/205* (2006.01)    *C23C 16/34* (2006.01)
*C23C 16/509* (2006.01)

(21) Application number: **06782264.3**

(22) Date of filing: **03.08.2006**

(86) International application number:
**PCT/JP2006/315404**

(87) International publication number:
**WO 2007/018121 (15.02.2007 Gazette 2007/07)**

(84) Designated Contracting States:
**DE FR**

(30) Priority: **05.08.2005 JP 2005228727**

(71) Applicant: **Sekisui Chemical Co., Ltd.**
**Osaka 530-8565 (JP)**

(72) Inventors:
 • **NAGATA, Takahiro**
   **Tsukuba-shi, Ibaraki 305-0047 (JP)**
 • **CHIKYO, Toyohiro**
   **Tsukuba-shi, Ibaraki 305-0047 (JP)**
 • **UEHARA, Tsuyoshi**
   **Tsukuba-shi, Ibaraki 300-4247 (JP)**

(74) Representative: **Merkle, Gebhard**
   **ter Meer Steinmeister & Partner GbR**
   **Mauerkircherstrasse 45**
   **D-81679 München (DE)**

(54) **METHOD FOR FORMING FILM OF GROUP III NITRIDE SUCH AS GALLIUM NITRIDE**

(57)     [PROBLEM TO BE SOLVED]
    To film deposit a group III nitride such as GaN using atmospheric pressure plasma.
    [SOLVING MEANS]
    A reactor chamber 12 is filled with a pure nitrogen of approximately atmospheric pressure of about 40 kPa. A c-face sapphire substrate 90 is placed on an electrode 14. The substrate temperature is brought to 650 degree centigrade by a heater 15. An electric field is applied between electrodes 13, 14 to form a discharge space 11a therebetween. In a gas feed system 20, a small quantity of trimethylgallium is added to $N_2$, the resultant is fed into a discharge space 11a and brought into contact with the sapphire substrate 90. A V/III ratio on the substrate 90 is brought into a range of from 10 to 100000.

[FIG. 1]

EP 1 916 704 A1

**Description**

TECHNICAL FIELD

This invention relates to a method for film depositing a group III nitride, such as gallium nitride (GaN), aluminium gallium nitride (AlGaN), aluminium nitride (AlN) or indium nitride (InN) on a substrate.

BACKGROUND TECHNIQUE

A group III nitride semiconductor, such as GaN, AlGaN, AlN or InN is expected to be applied not only to an optical emission element but also to a high frequency element. Conventional examples of the method for film depositing a group III nitride are listed below.

1) MOCVD utilizing ammonia
2) MBE utilizing high vacuum plasma
3) MBE under high vacuum utilizing ammonia
4) MOCVD utilizing high vacuum plasma
5) laser abrasion under ultrahigh vacuum

PATENT DOCUMENT 1: Japanese Patent Application Laid-Open No. H10-106958
PATENT DOCUMENT 2:Japanese Patent Application Laid-Open No. H04-164859
NON-PATENT DOCUMENT 1: Development/Application Trend of Compound Semiconductor, Electronic Material (2004) p18-41
NON-PATENT DOCUMENT 2: Advanced Electronics I-21. Group III Nitride Semiconductor, written by Isamu Akazaki, issued by Baifukan (1999)

DISCLOSURE OF INVENTION

PROBLEM TO BE SOLVED

It is demanded that the group III nitride semiconductor as a substrate can be applied not only to sapphire but also to Si, to high molecular material, or to the like in order to expand the application field of a group III nitride semiconductor such as GaN to electronic devices such as high frequency elements from optical devices such as LED.
On the other hand, a ratio (V/III ratio) between a group III material and a reactive nitrogen source is closely related to the growth of a group III nitride film. The V/III ratio is controlled by increasing the pressure to about several Pa under a vacuum condition using ammonia as a nitrogen source in the above-mentioned film depositing methods 1) and 3) or the like. However, it is necessary to increase the growth temperature to such a high temperature as 1000 degree centigrade or more in order to thermally decompose ammonia. This makes it difficult to use Si and a high molecular material as a substrate, thereby limiting the application range of the group III material. Also, a large-scaled detoxifying facility and a high vacuum device are required for ammonia.
The present invention has been made in view of the above-mentioned situation. It is, therefore, an object of the invention to expand the application range by lowering the substrate temperature and to simplify the facility.

MEANS TO SOLVING THE PROBLEM

In order to achieve the above object, the inventors of the present invention have made a proposal to film deposit a group III nitride such as GaN using an atmospheric pressure plasma (plasma caused by glow discharge or the like in the vicinity of atmospheric pressure), and carried out extensive search and investigation and accomplished the present invention which will be described hereinafter.
The present invention provides a method for growing a group III nitride on a substrate, characterized in the method comprises the steps of:

forming a discharge space by applying an electric field between a pair of electrodes under atmosphere in the vicinity of atmospheric pressure; and
bringing a nitrogen, which is introduced into the discharge space, and a metal compound containing a group III metal into contact with the substrate such that a V/III ratio is within a range of from 10 to 100000.

The V/III ratio used herein refers to a ratio between a feed partial pressure of the group V material and a feed partial pressure of the group III material.

A lattice mismatching ratio of the substrate with respect to the group III nitride is preferably as small as possible, for example, 0 to 20%. However, the a-face sapphire is an exception. An epitaxial growth may in some instance occur depending on atom arrangement in actual crystal growth, even if the lattice mismatching ratio is large. Particularly, a substance having a c-axis orientation, such as GaN or ZnO, exhibits this tendency prominently. The c-face sapphire also possesses this tendency.

The lattice mismatching ratio can be defined by the following expression.

$$\text{lattice mismatching ratio} = (a_{film} - a_{sub}) / a_{sub}$$

wherein $a_{film}$ is a lattice constant in the a-axis direction of the nitrogen thin film, and $a_{sub}$ is a lattice constant in the a-axis direction of substrate crystal.

The V/III ratio may be within the above-mentioned range only when the plasma gas contacts the substrate. In case where the V/III ratio varies depending on position (for example, the group III material such as Ga is consumed as it goes toward the downstream of the gas stream and the V/III ratio is increased), the plasma gas may contact the substrate only at such position where the V/III ratio is within the desired range.

The group III metal is preferably selected from Ga, Al and In, and the group III nitride to be obtained is preferably selected from GaN, AlGaN, AlN and InN.

In case where a gallium containing compound is used as the metal compound, a gallium nitride (GaN) is generated as the group III nitride.

The gallium containing compound is preferably selected from the group consisting of trimethylgallium ($(CH_3)_3Ga$, hereinafter sometime referred to as "TMG"), triethylgallium ($(CaH_5)_3Ga$, hereinafter sometime referred to as "TEG"), quinuclidinegallane ($GaH_3:N(C_7H_{13})$, hereinafter sometime referred to as "QUG") and 1-methylpyrrolidinegallane ($GaH_3:N(CH_3)(C_4H_4)$, hereinafter sometime referred to as "1-MPG"). Besides the above ones, trichlorogallium ($GaCl_3$, hereinafter sometime referred to as "TCG"), gallium dimethylamide ($Ga_2[N(CH_3)_2]_6$, hereinafter sometime referred to as "DMEGA") and the like may be used as the gallium containing compound. It is also accepted that a mixture containing two or more of those gallium containing compounds is used.

In case where an aluminium containing compound is used as the metal compound, aluminium nitride (A1N) is generated as the group III nitride.

The aluminium containing compound is preferably selected from the group consisting of triethylaluminium ($(C_2H_5)Al$, hereinafter sometime referred to as "TEA"), 1-methylpyrrolidinealane ($AlH_3:N(CH_3)(C_4H_4)$, hereinafter sometime referred to as "1-MPA"), dimethylaluminium hydride ($(CH_3)_2AlH$, hereinafter sometime referred to as "DMAH"), aluminium dimethylamide ($Al_2[N(CH_3)_2]_6$, hereinafter sometime referred to as "DMEAA") and, quinuclidinealane ($AlH_3:N(C_7H_{13})$, hereinafter sometime referred to as "QUA"). It is also accepted that a mixture containing two or more of those aluminium containing compounds is used.

The substrate is preferably selected from c-face sapphire, a-face sapphire, ZnO, GaN, SiC and GaAs.

In case where a c-face or a-face sapphire substrate is used as the substrate and a gallium containing compound is used as the metal compound and the V/III ratio is set within a range of from 10000 to 100000, GaN can be epitaxially grown on the substrate. In case where the V/III ratio is set within a range of from about 10 to 1000, a polycrystal of GaN can be obtained.

In case where the substrate is an aluminium containing substrate such as sapphire ($Al_2O_3$), aluminium gallium nitride (AlGaN) can be grown as a III group nitride on the substrate by using a gallium containing compound as the metal compound for the group III material without separately adding an aluminium containing compound. GaN can be grown on the AlGaN layer.

In order to prevent organic compounds caused by organic composition of the group III material from mixing into the film, the substrate temperature is preferably brought into a range of from 500 degree centigrade to 700 degree centigrade, more preferably about 650 degree centigrade, although film deposition reaction itself does not require heating of the substrate much. The upper limit of the substrate temperature may be about 700 degree centigrade and such high temperature as 1000 degree centigrade or more is not required. The reaction rate can sufficiently be obtained even by such degree of substrate temperature or so. Since the organic composition contained in the group III material can be removed from the substrate by evaporation, the organic composition can be prevented from mixing into the film.

The lower limit of the substrate temperature is preferably set in such a manner as to correspond to thermal decomposition temperature of the metal compound of the group III material.

In case where the metal compound is TMG, the lower limit of the substrate temperature can be set to about 300 degree centigrade. A polycrystal GaN or an amorphous GaN can be obtained at a temperature near the lower limit temperature. In order to obtain an epitaxial GaN crystal, the substrate temperature is preferably set to about 400 degree centigrade or more, and more preferably within a range of from 450 degree centigrade to 500 degree centigrade or more.

It is known that TEG, QUG and 1-MPG are thermally decomposable even at temperature about 100 degree centigrade lower than the temperature of TMG. Accordingly, in case where the metal compound is TEG, QUG or 1-MPG, the lower limit of the substrate temperature can be set to about 200 degree centigrade in order to obtain a polycrystal GaN or an amorphous GaN and about 300 degree centigrade in order to obtain an epitaxial crystal of GaN. Preferably, in case of TEG, the substrate temperature is set within a range of from 350 degree centigrade to 450 degree centigrade or more. With respect to QUG, it is already confirmed by means of experiment (atmospheric pressure: 2 x 10E$^{-8}$ Torr, supply pressure: 5 x 10E$^{-5}$) carried out by the inventors that it can be decomposed to Ga at a temperature within a range of from about 200 degree centigrade to 300 degree centigrade. In case of 1-MPG, in consideration of a printing matter (ULVAC TECHNICAL JOURNAL No.59 2003 P.25) relating to 1-MPA which is a similar material as 1-MPG, the lower limit of the substrate temperature can be set within a range of from 150 degree centigrade to 250 degree centigrade.

Film deposition processing is carried out preferably under nitrogen atmosphere and more preferably under pure nitrogen (which, however, may contain inevitable impurities) atmosphere. The nitrogen density as the above-mentioned atmosphere is preferably 99.9 vol % or more.

The pressure of atmosphere can properly be set within a range where atmospheric nitrogen plasma or the like can be obtained, and preferably within a range of from 40 kPa to 100 kPa. It is preferable to apply a voltage between a pair of electrodes under atmosphere of nitrogen or the like in the vicinity of the atmospheric pressure.

The electrode construction is preferably a parallel plate electrode. The plasma irradiation system may be a direct system wherein a substrate is directly arranged within a discharge space between a pair of electrodes or may be a remote system wherein a substrate is disposed outside a discharge space and plasma gas generated in the discharge space is sprayed onto the substrate.

The charging voltage may be of magnitude enough to occur stable discharge between the electrodes by nitrogen or the like. For example, in case where the nitrogen atmosphere pressure is about 40 kPa, about Vpp = 300 V through 1000 V is suitable.

The frequency is, for example, within a range of from 10 kHz to 30 kHz. The voltage waveform is, for example, a bipolar pulse but it is not limited to this.

The distance between the pair of electrodes is long enough to form an atmosphere pressure plasma discharge between those electrodes within a range of from about 0 point several millimeters to several millimeters.

In the direct system, the thickness of a gap formed between a surface facing the substrate of one of the two electrodes and the substrate is preferably within a range of from 0.1 mm to 5 mm, and more preferably about 0.5 mm.

## EFFECT OF THE INVENTION

According to the present invention, a group III nitride such as GaN can be grown on a substrate of sapphire or the like using nitrogen plasma in the vicinity of atmospheric pressure. The V/III ratio can be set sufficiently large and the reaction rate can be increased. The substrate temperature can be set lower compared with the case where the conventional ammonia is used, and the selection range of the substrate material can be expanded, and thus, the application range of the group III nitride semiconductor can be expanded. A large-scaled detoxifying facility and a high vacuum device are no more required, and the facility can be simplified.

[BRIEF DESCRIPTION OF THE DRAWINGS

[FIG. 1]

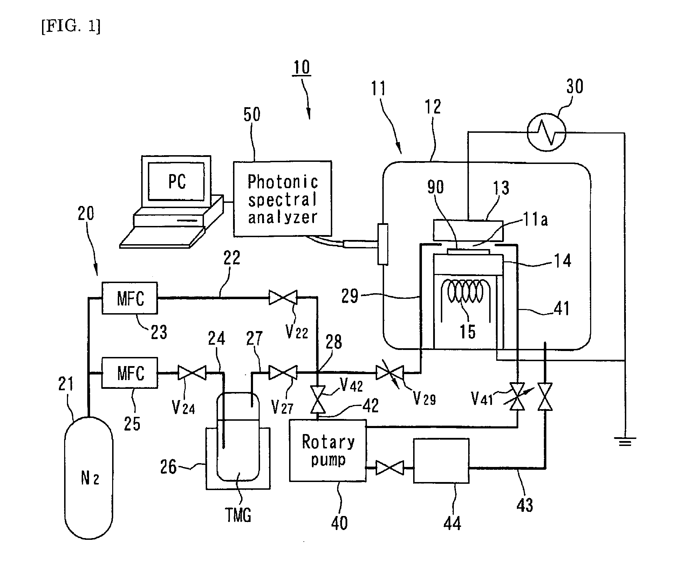

FIG. 1 is a circuit diagram of an atmospheric pressure nitrogen plasma CVD apparatus according to one embodiment of the present invention.
[FIG. 2]

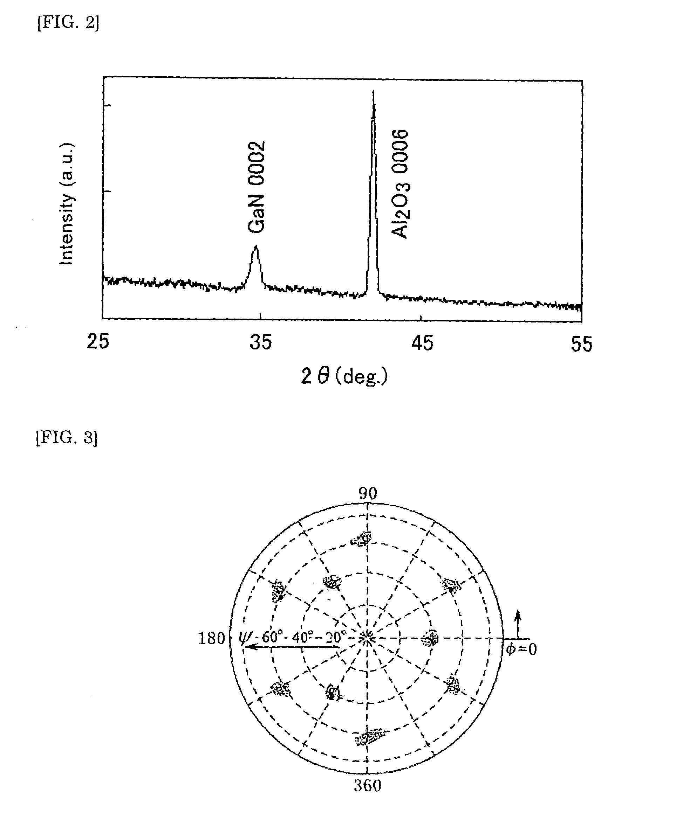

FIG. 2 is a ω-2θ scan diffraction diagram of a sample of Embodiment 1.
[FIG. 3]
FIG. 3 is an analysis image of a sample of Embodiment 1 according to the pole figure process.
[FIG. 4]

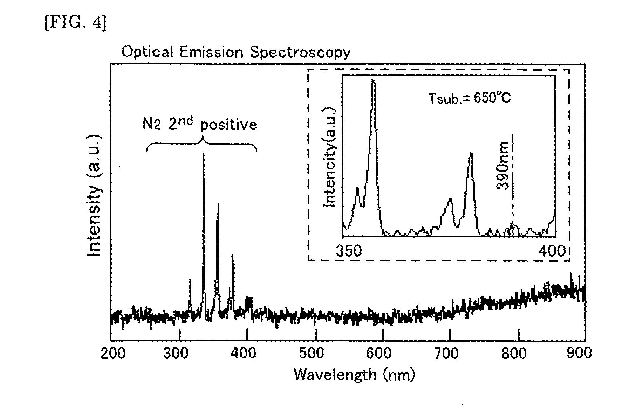

FIG. 4 is an optical spectroscopy in a discharge space according to Reference Experiment 1-1.
[FIG. 5]

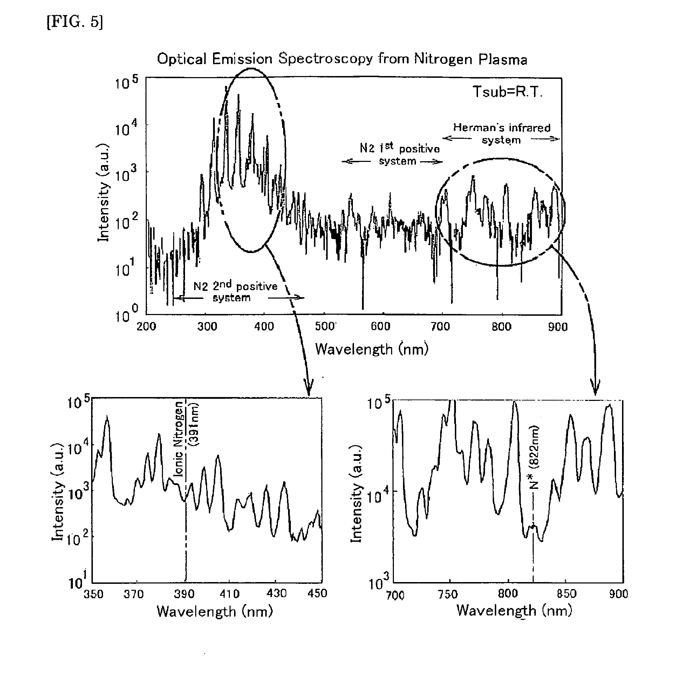

FIG. 5 is an optical spectroscopy of optical emission from a discharge space according to Reference Experiment 1-2.
[FIG. 6]

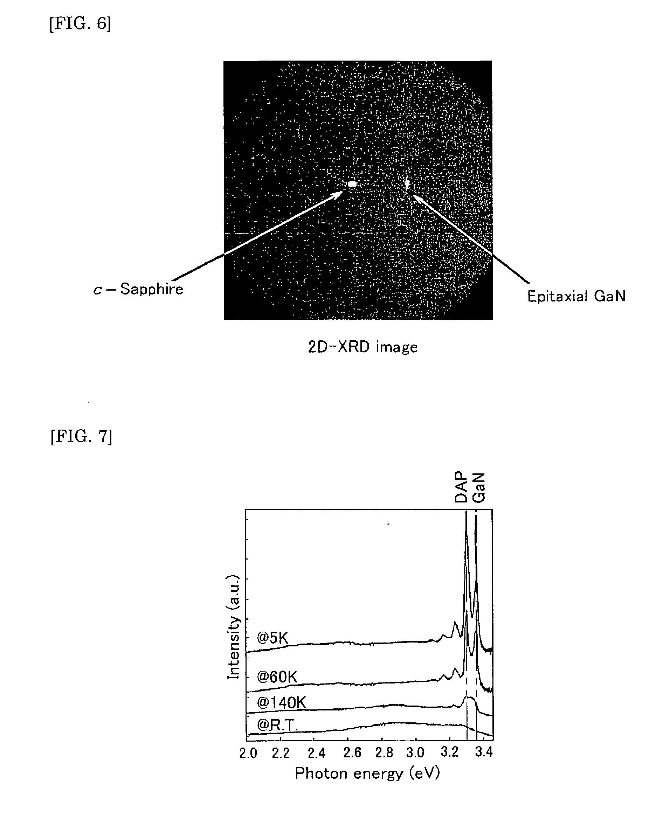

FIG. 6 is a two-dimensional X-ray diffraction image of a sample of Embodiment 2.
[FIG. 7]

FIG. 7 is a photoluminescence spectroscopy of a sample of Embodiment 2, wherein marks following "@" indicate measurement temperatures.
[FIG. 8]

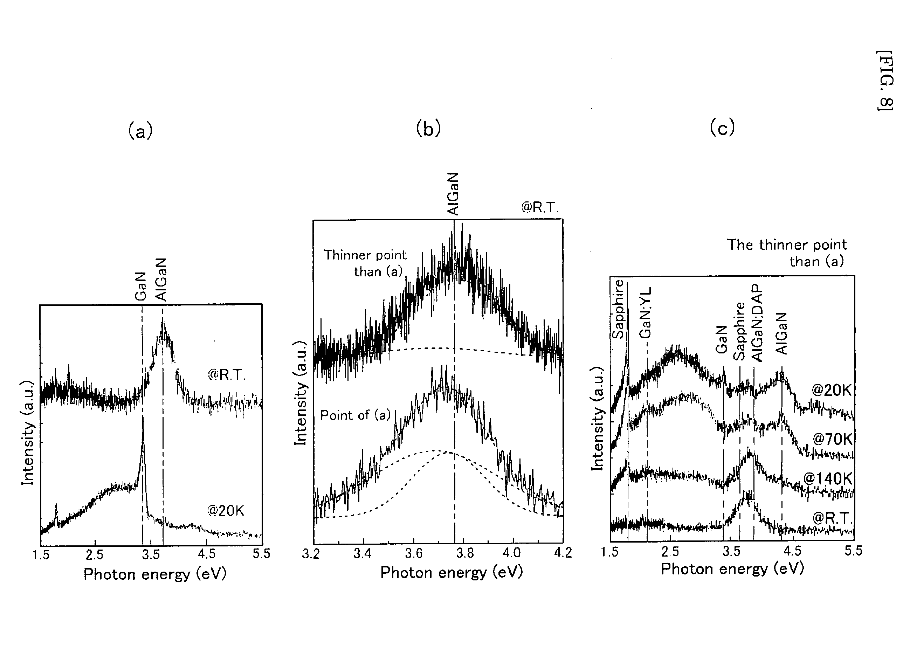

FIG. 8 is a cathode luminescence spectroscopy of a sample of Embodiment 2, wherein (a) shows measurement results, one obtained under room temperature and the other under temperature of 20K, at a position of the sample where the film thickness is large, (b) shows a comparison of the measurement results under room temperature, one at a position of the sample where the film thickness is large and the other at a position of the sample where the film thickness is small, and (c) shows measurement results for respective measurement temperatures at the position where the film thickness is small.
[FIG. 9]

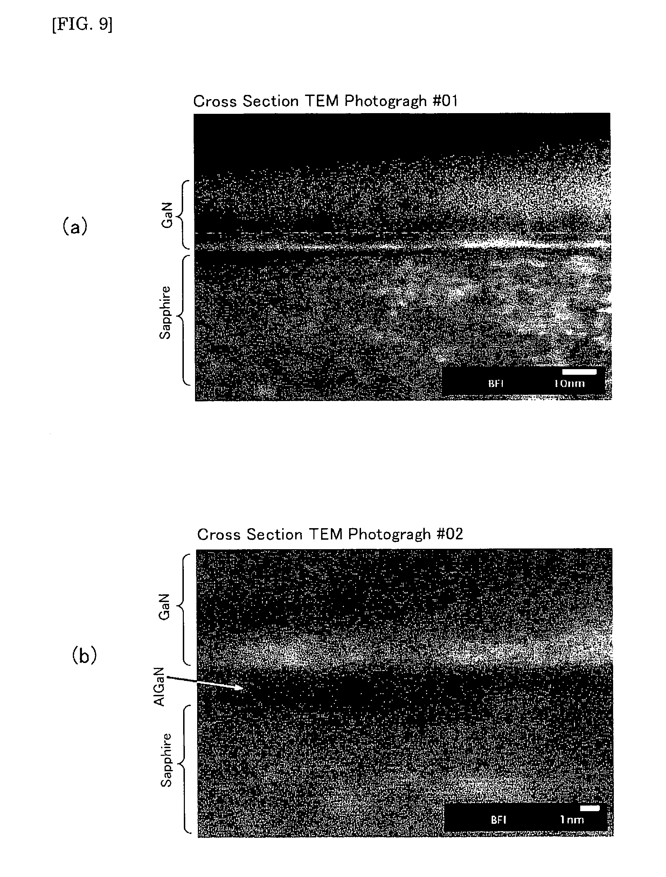

FIG. 9 is a cross section TEM photograph of the sample of Embodiment 2, (a) shows a photograph where the scale is relatively increased and (b) shows a photograph where the scale is relatively decreased.
[FIG. 10]

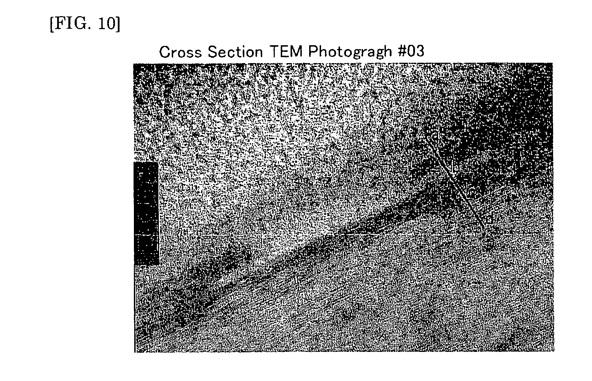

FIG. 10 is a cross section TEM photograph of the sample of Embodiment 2 but taken at a position of the sample different from FIG. 9.
[FIG. 11]

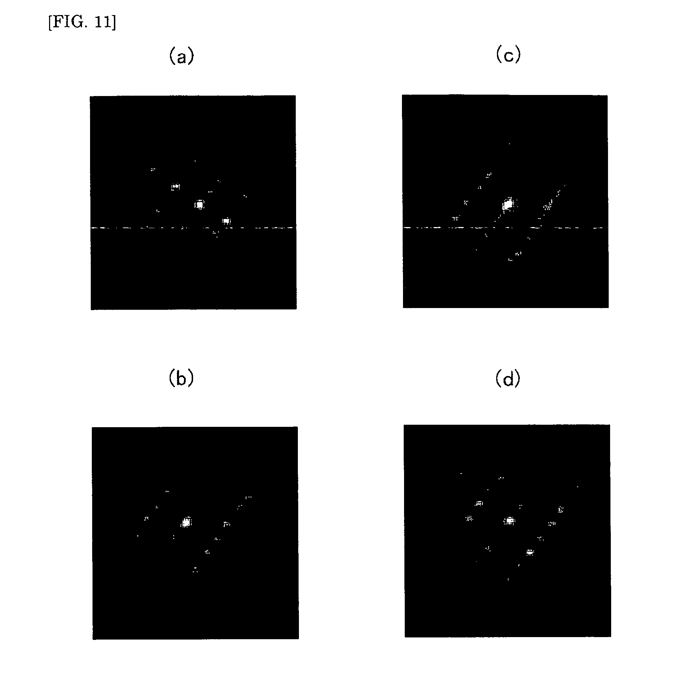

FIG. 11 shows x-ray diffraction photographs, (a) taken at a-spot of FIG. 10, (b) at b-spot of FIG. 10, (c) at c-spot of FIG. 10 and (d) at d-spot of FIG. 10, respectively.
[FIG. 12]

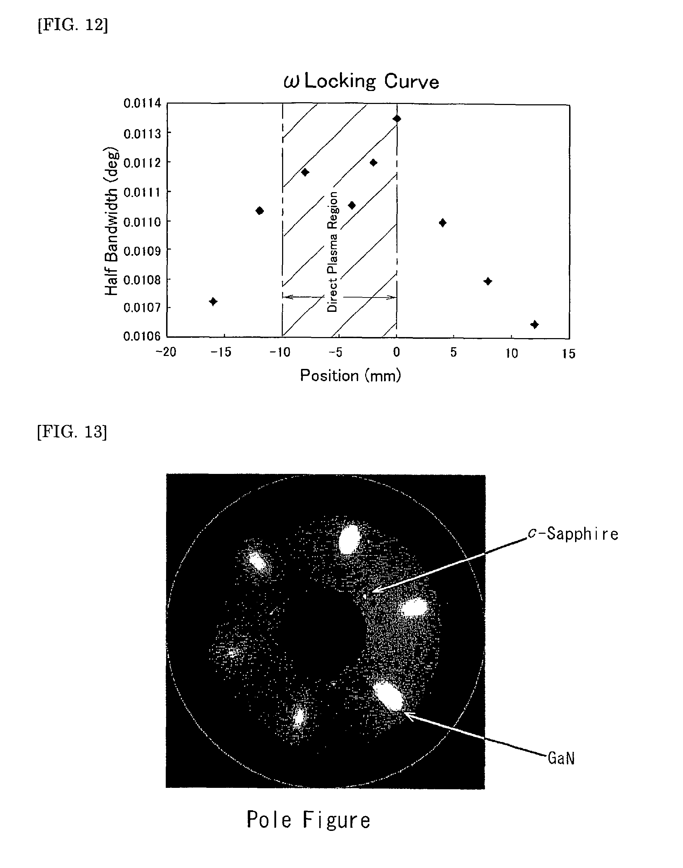

FIG. 12 is a graph showing a half bandwidth ($\omega$ locking curve) at respective spots on a sapphire substrate after the nitrogen plasma radiation is carried out according to Reference Experiment 2.
[FIG. 13]
FIG. 13 is a photograph showing a pole figure of a sample for which a film deposition process was carried out at a substrate temperature of 400 degree centigrade in Embodiment 3.
[FIG. 14]

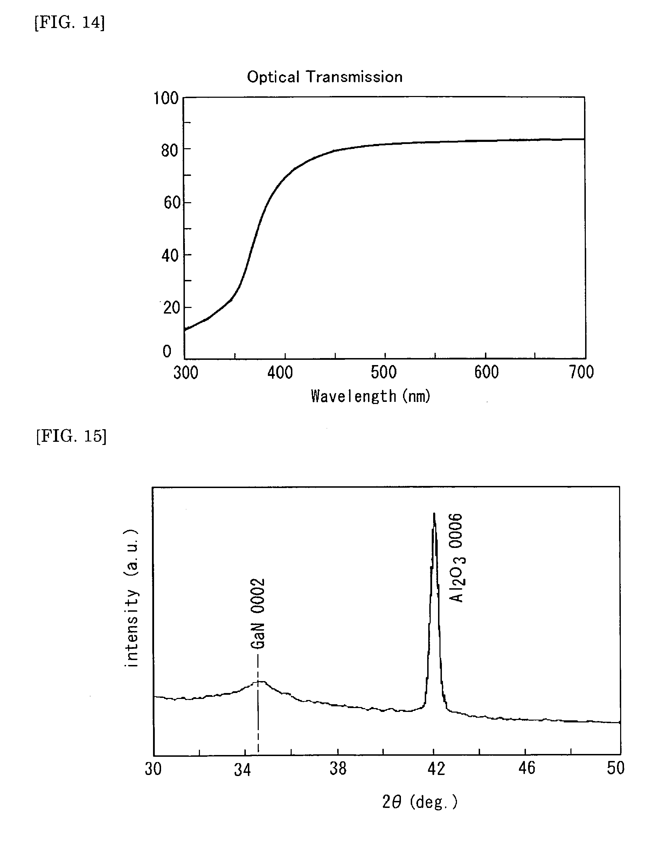

FIG. 14 is a graph showing the measurement result of optical transmission of the sample of FIG. 13.
[FIG. 15]
FIG. 15 is a $\omega$-$2\theta$ scan diffraction diagram of the sample for which a film deposition processing was carried out at a substrate temperature of 350 degree centigrade in Embodiment 3.
[FIG. 16]

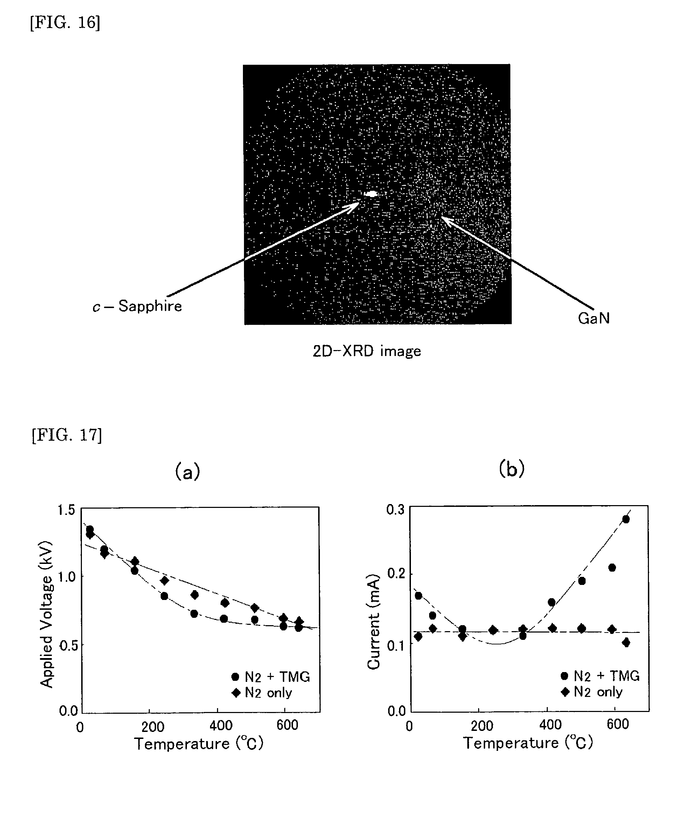

FIG. 16 is a two dimensional x-ray diffraction image of the sample of FIG. 15.
[FIG. 17]
FIG. 17(a) is a graph showing the result of measurement of the lower limit application voltage where a stable discharge can be obtained, by varying the substrate temperature and process gas in Reference Experiment 3-1, and FIG. 17(b) is a graph showing a supply electric current in the lower limit voltage of FIG. 17(a).
[FIG. 18]

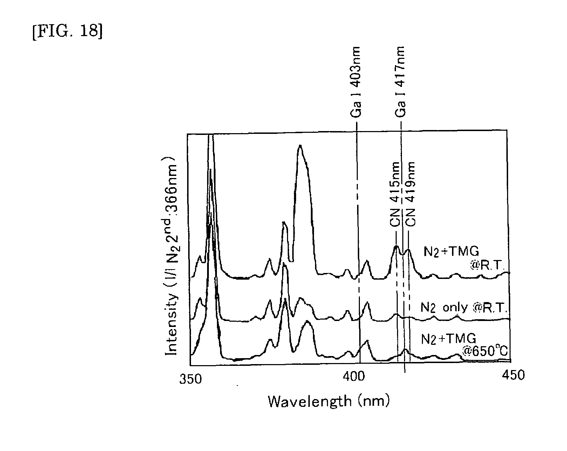

FIG. 18 is a spectroscopy of optical emission from the discharge space in Reference Experiment 3-1.
[FIG. 19]

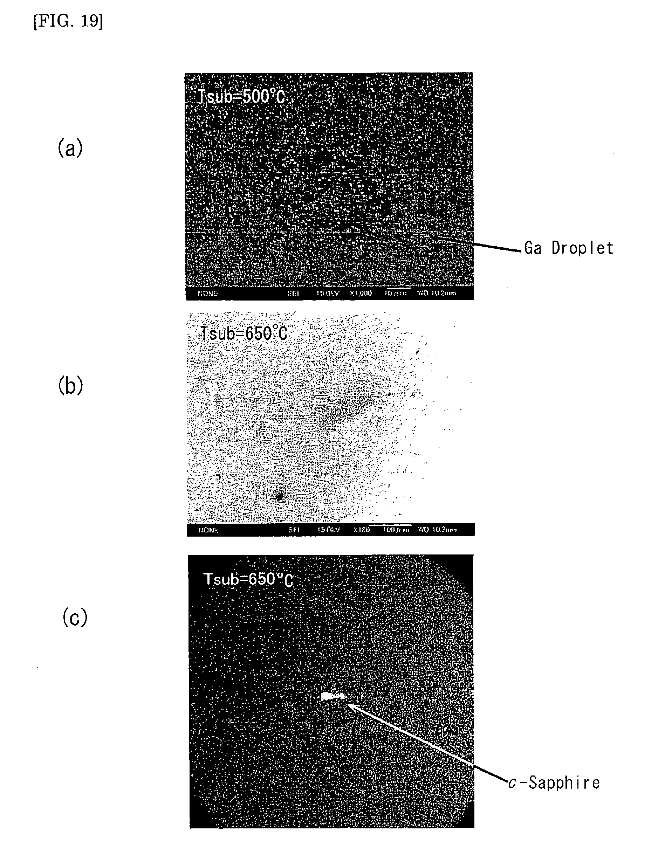

FIG. 19 shows the result of Reference Experiment 3-2, (a) is a microscope photograph of the substrate surface in case where process gas, without being plasmatized, is sprayed onto the substrate at the substrate temperature of 500 degree centigrade, (b) is a microscope photograph in case of the substrate temperature of 650 degree centigrade in (a), and (c) is a two-dimensional x-ray diffraction image of the same sample as in (b).

DESCRIPTION OF REFERENCE NUMERAL

10.....film deposition apparatus
11.....reactor
11a.....electric discharge space between electrodes
12.....chamber
13.....upper hot electrode
14.....lower earth electrode
15.....heater
20....gas feed system
21.....N$_2$ tank
22.....N$_2$ tank feed path
23.....main mass flow controller (main MFC)

V22.....stop valve
24.....carrier feed path
25.....carrier mass flow controller (carrier MFC)
V24..... stop valve
26.....thermostatic bath
27.....TMG adding path
V27.....stop valve
28.....joining part between an $N_2$ feed path and a TMG adding path
29.....common feed path
V29.....opening control valve
30.....power source
41.....outlet path
V41.....opening control valve
40.....rotary pump
42.....purge path
43.....exhaust path
44.....turbo molecular pump
V42.....stop valve
50.....photonic spectral analyzer
90.....sapphire substrate

BEST MODE FOR CARRYING OUT THE INVENTION

The present invention is applied to techniques where a group III nitride such as GaN, AlGaN, AlN or InN is film deposited on a substrate by CVD method.
In this embodiment, GaN is film deposited on a substrate which is composed of a c-face sapphire or a-face sapphire $(Al_2O_3)$.
$N_2$ is used as a group V material.
TMG, for example is used as a group III material.
A V/III ratio is selected from within a range of from 10 to 100000.
TMG as a group III material is added to $N_2$ as a group V material in a quantity defined by the V/III ratio. As this adding means, a bubbling method using $N_2$ may be employed. Thus obtained process gas which consists of a mixed gas of $N_2$ and TMG is introduced into a plasma space. By doing so, $N_2$ is decomposed and N radical, etc. are obtained. It is estimated that not only $N_2$ but also TMG is decomposed and as a result, such active species as Ga radical, Ga ion, etc. are generated. Plasma gas containing those active species contacts a sapphire substrate, so that a GaN layer can be grown.
This embodiment will be described in more detail.
FIG. 1 shows one example of an atmospheric pressure nitrogen plasma CVD apparatus 10 of direct type for carrying out the method of the present invention. The CVD apparatus 10 comprises a reactor 11 and a gas feed system 20 for feeding a reaction gas to the reactor 11.
The reactor 11 includes a chamber 12, a pair of electrodes 13, 14 and a heater 15. A space 11a within the chamber 12 is filled with pure nitrogen gas ($N_2$). Nitrogen pressure within the chamber 12 is set to about 40 kPa.
The pair of electrodes 13, 14 and the heater 15 are housed in the chamber 12.
The pair of electrodes 13, 14 are arranged in vertically opposite relation and thus, they constitute parallel plate electrodes. The upper electrode 13 is connected to a power source 30 and thus, it constitutes a hot electrode. The lower electrode 14 is electrically earthed and thus, it constitutes an earth electrode. A lower surface of the hot electrode 13 and an upper surface of the earth electrode 14 are provided with solid dielectric layers (not shown), respectively. The thickness of each solid dielectric layer is preferably about 1 mm. At least one of the electrodes may be provided with the solid dielectric layer.
The power source 30 outputs a voltage of bipolar pulse waveform, Vpp = 500 V, about 30 kHz frequency. Voltage waveform, voltage, frequency, etc. of the power source 30 are not limited to those mentioned above but they may be changed, where necessary.
By voltage fed to the electrode 13 from the power source 30, an electric field is formed between the pair of electrodes 13, 14, and the interelectrode space 11a serves as an electric discharge space.
A substrate 90 composed of c-face sapphire or a-face sapphire, which substrate 90 is an object to be processed, is arranged at a central part on an upper surface of the earth electrode 14. The earth electrode 14 also serves as a base on which the substrate 90 is placed.
A gap formed between the surfaces of the solid dielectric layers of the upper and lower electrodes 13, 14 is, for example, 1 mm, the thickness of the substrate 90 is, for example, 0.5 mm, and a gap formed between the lower surface of the solid dielectric layer of the hot electrode 13 and the upper surface of the substrate 90 is, for example, 0.5 mm. Those dimensions may be changed, where necessary.

A shallow recess for receiving the substrate 90 may be formed in the upper surface of the earth electrode 14.

The heater 15 is arranged underneath the earth electrode 14. The heater 15 may be embedded within the earth electrode 14. The earth electrode 14 is heated by the heater 15 and the substrate 90 is heated through this earth electrode 14. The substrate 90 is preferably heated to about 650 degree centigrade.

The gas feed system 20 for the rector 11 is constituted in the manner mentioned hereinafter.

An $N_2$ feed path 22 extends from a group V material $N_2$ tank 21. The $N_2$ feed path 22 is provided with a main mass flow controller 23 (hereinafter referred to as "main MFC") and a stop valve V22 which are arranged in order from the upstream.

A carrier feed path 24 is branched from the $N_2$ feed path 22 on the upstream side of the main MFC23. The carrier feed path 24 is provided with a carrier mass flow controller 25 (hereinafter referred to as "carrier MFC") and a stop valve V24 which are arranged in order from the upstream. A downstream end of the carrier feed path 24 is inserted inside a thermostatic bath 26 and open there.

TMG as a group III material is stored in the thermostatic bath 26. The thermostatic bath 26 keeps the temperature of TMG to, for example, 0 degree centigrade. Incidentally, the boiling point of TMG, under the atmospheric pressure, is 55.7 degree centigrade and the melting point is 15.9 degree centigrade. TMG within the thermostatic bath 26, at 0 degree centigrade, is in a liquid phase. A downstream end opening of the carrier feed path 24 is located under the liquid surface of TMG within the thermostatic bath 26.

A TMG adding path 27 extends from above the liquid surface of TMG within the thermostatic bath 26. The TMG adding path 27 is provided with a stop valve V27. A downstream end of the TMG adding path 27 is joined with the $N_2$ feed path 22 located at the downstream of the stop valve V22.

A common feed path 29 extends from a joining part 28 between the $N_2$ feed path 22 and TMG adding path 27. The common feed path 29 is provided with an opening control valve V29. A downstream end of the common feed path 29 is inserted within the chamber 12 of the reactor 11 and open in such a manner as to face with one end of the interelectrode space 11a.

An outlet path 41 extends from the other end of the interelectrode space 11a. The outlet path 41 is provided with an opening control valve V41. A rotary pump 40 is connected to a downstream end of the outlet path 41.

A purge path 28 extends from the joining part 28 and is connected to the rotary pump 40.

An exhaust path 43 extends from the chamber 12 of the reactor 11 and is connected to the rotary pump 40 through a turbo molecular pump 44.

The atmospheric pressure nitrogen plasma CVD apparatus 10 thus constructed is used in the following manner. The inside of the gas feed system 20 is preliminarily purged by opening the purge path 42. After purging operation, the purge path 42 is closed by a stop valve V42.

Air within the chamber 12 of the reactor 11 is exhausted by the turbo molecular pump 44 and $N_2$ is supplied from the $N_2$ tank 21 into the chamber 12, so that the inside of the chamber 12 is filled with pure nitrogen. The nitrogen pressure within the chamber 12 is kept to 40 kPa which is in the vicinity of atmospheric pressure.

Accordingly, it is no more necessary to create a high vacuum and thus, a large-scaled vacuum facility is no more required.

The sapphire substrate 90 is set to a central part of the earth electrode 14. This substrate 90 is heated to 650 degree centigrade by the heater 15.

Then, $N_2$ is allowed to flow to the $N_2$ feed path 22 from the $N_2$ tank 21. Part of $N_2$ is branched to the carrier feed path 24. The flow rate of $N_2$ of the $N_2$ feed path 22 is controlled by the main MFC 23, while the flow rate of $N_2$ of the carrier feed path 24 is controlled by the carrier MFC 25. The flow rate of $N_2$ of the $N_2$ feed path 22 (excluding the part branched to the carrier feed path 24) is, for example, 200 sccm to 500 sccm, while the flow rate of $N_2$ of the carrier feed path 24 is, for example, 0.5 sccm to 1 sccm.

$N_2$ of the carrier feed path 24 is blown into the liquid-phase TMG of the thermostatic bath 26. As a result, TMG is bubbled and evaporated. The evaporating amount of TMG depends on the $N_2$ flow rate in the carrier feed path 24. Because the TMG is cooled down to 0 degree centigrade in the thermostatic bath 26, the evaporation amount without being evaporated by bubbling is almost negligible and thus, the evaporating amount can correctly be controlled.

The evaporated TMG, together with the carrier $N_2$, is joined with $N_2$ of the $N_2$ feed path 22 via the TMG feed path 27. By this, a process gas, which is obtained by adding a predetermined small amount of TMG to $N_2$, is generated. This process gas is introduced into the interelectrode space 11a of the reactor 11 via the common feed path 29.

In parallel with the gas feeding operation, the power source 30 is driven to apply an electric field between the pair of electrodes 13, 14. This builds up an atmospheric glow discharge between the electrodes 13, 14 and the interelectrode space 11a is turned out to be an electric discharge space. $N_2$ in the process gas is decomposed in this discharge space 11a and a nitrogen plasma is generated. It is estimated that TMG is also decomposed.

The plasma gas in the interelectrode space 11a contacts the sapphire substrate 90, thereby to form a GaN layer on the surface of the sapphire substrate 90.

In addition, a thin layer of AlGaN is formed on an interface between the sapphire substrate 90 and the GaN layer. The GaN layer is laminated on this AlGaN layer. It is estimated that Al contained in AlGaN is provided from the sapphire substrate. Therefore, it is not necessary to separately mix the Al source to the process gas in order to form the AlGaN layer.

By stopping the film deposition process before the film glowing component is turned to GaN from AlGaN, it is possible to form only the AlGaN layer. Thereafter, a film having a component different from that of GaN can be formed on the AlGaN layer by way of a separate process.

Since a nitrogen plasma in the vicinity of atmospheric pressure is used, the V/III ratio can be increased at a reaction site and a reaction rate can be gained.

The sapphire substrate 90 is arranged at the central part of the earth electrode 14 where turbulence of electric field hardly occurs and the plasma state is stable and uniform. Thus, the film quality of GaN can be equalized.

Heating of the substrate 90 by the heater 15 makes it possible to further increase the reaction rate and to evaporate organic compounds attributable to the methyl group of TMG and thus, the organic compounds can be prevented from mixing into the film. The processed gas containing those organic compounds is sucked into the outlet path 41 from the interelectrode space 11a and exhausted.

The temperature required for heating the substrate 90 is only about 650 degree centigrade. This substrate temperature is considerably low when compared with 1000 degree centigrade employed in the conventional film deposition method using ammonia and thus, the high-temperature facility can be simplified. In addition, no detoxifying facility is required. This method can also be applied to such substrates as having a small heat-resisting property and thus, the selective range of the substrates can be expanded. The application capability is expanded to such substrates as being composed of high molecular material such as flexible film.

According to the atmospheric pressure nitrogen plasma CVD apparatus 10, the $N_2$ flow rate of the $N_2$ feed path 22 can be controlled by the main MFC 23, while the $N_2$ flow rate of the carrier feed path 24 and thus, the adding amount of TMG can be controlled by the carrier MFC 25. Therefore, the V/III ratio on the sapphire substrate 90 can be controlled by the two MFCs 23, 25, thus making it possible to select the crystal structures of GaN.

That is to say, by setting such that the V/III ratio on the sapphire substrate 90 is within a range of from about 10000 to 100000, GaN can be epitaxially grown on the substrate 90. By setting such that the V/III ratio is within a range of from about 10 to 1000, a polycrystalline GaN can be obtained.

The substrate temperature, at the reaction time, is preferably set to about 400 degree centigrade or more in order to obtain an epitaxial crystal, and preferably to about 300 degree centigrade or more in order to obtain a polycrystal.

Present invention is not limited to the above embodiment.

Instead of the c-face or a-face sapphire substrate, ZnO, SiC, GaAs or the like may be used as the substrate. A suitable substrate has a small mismatching of lattice to a film to be obtained. The mismatching percentage of lattice is preferably small, for example, about 0 to 20 %. Incidentally, the lattice mismatching percentage between the c-face sapphire and GaN is 16 %.

Instead of TMG, TEG, QUG or 1-MPG may be used as a Ga material. Moreover, TCG, DMEGA or the like may be used as a Ga material.

In case where TEG, QUG or 1-MPG is used as a Ga material, the lower limit of the substrate temperature range can be made lower by about 100 degree centigrade than the temperature in case where TMG is used. In case where an epitaxial crystal is a substance to be obtained, the substrate temperature can be brought to about 300 degree centigrade or more, and in case where a polycrystal is a substance to be obtained, the substrate temperature can be brought to about 200 degree centigrade or more.

In case where TMG is consumed during the time when the process gas ($N_2$ + TMG) flows from one end of the discharge space 11a to the central part where the sapphire substrate 90 is located, the initial V/III ratio may be controlled such that a desired V/III ratio can be obtained just on the substrate 90, by taking into consideration the above-mentioned consumed amount.

It may be arranged such that a desired V/III ratio can be obtained just on the substrate 90 by adjusting the length from the time when the process gas ($N_2$ + TMG) is introduced to the discharge space 11a to the time when the process gas arrives on the substrate 90.

It may also be arranged such that the V/III ratio is substantially constant at any position on the substrate 90 by controlling the gas flow in the discharge space 11a.

A mask may be applied onto the substrate 90 at any other position than the position where the V/III ratio is within a desired range.

Instead of preliminarily mixing $N_2$ with TMG and introducing the mixture between the electrodes, $N_2$ and TMG may be introduced between the electrodes via separate routes, respectively.

The so-called remote system, in which a substrate is arranged outside a plasma space, may be employed as a plasma radiation structure. In that case, an arrangement may be made such that only $N_2$ is passed between the electrodes and sprayed onto the substrate and TMG is separately sprayed onto the substrate.

EMBODIMENT 1

One embodiment will now be described. It should be noted, however, that the present invention is not limited to this embodiment.
A film deposition processing was carried out under the following conditions, using the apparatus 10 of FIG. 1.

 $N_2$ flow rate of $N_2$ feed path 22: 300 sccm
 $N_2$ flow rate of carrier feed path 24: 1 sccm
 substrate: c-face sapphire
 substrate temperature: 650 degree centigrade
 processing pressure: 40 kPa
 voltage mode: bipolar pulse wave
 charging voltage: Vpp = 500 V
 frequency: 30 kHz
 growth time: 30 min

A sample obtained by the processing of this Embodiment 1 was ω-2θ scan analyzed according to the X-ray diffraction method. As a result, diffraction from the 0002 plane of GaN was confirmed as shown in FIG. 2. Also, the above-mentioned sample was analyzed according to the pole figure method. As a result, 6-times symmetry attributable to a hexagonal structure of the GaN single crystal was confirmed. From the foregoing, it was confirmed that a GaN film was epitaxially grown on a sapphire substrate in the 0001 direction.

[REFERENCE EXPERIMENT 1-1]

In the apparatus 10 of FIG. 1, optical emission from the interelectrode space 11a was analyzed by a photonic spectral analyzer 50. The substrate temperature (Tsub) was set to 650 degree centigrade and only nitrogen was fed into the interelectrode space 11a. As a result, a peak attributable to the 2nd positive system of nitrogen appeared as shown in FIG. 4 and generation of nitrogen plasma was confirmed. It was confirmed that since the plasma is an atmospheric pressure plasma, a main peak appears in a 2nd positive region equal to or less than 337 nm on the higher energy side than in the case of pressure-reduced plasma (414 nm = 2. 997 eV).
An insertion Figure encircled with a frame of broken lines in FIG. 4 is an enlargement of a portion covering the wavelength ranging from 350 nm to 400 nm. A peak (390 nm) of ion species, which causes damage to film, was not confirmed.

[REFERENCE EXPERIMENT 1-2]

Optical emission from the interelectrode space 11a was analyzed under the following conditions, using a separate photonic spectral analyzer.

 processing pressure (nitrogen atmospheric pressure): 40 kPa plusminus 2 kPa
 feeding gas: only nitrogen, 400 sccm
 substrate temperature : room temperature

The result is shown in FIG. 5. As shown left down on an enlarged scale, a peak did not appear at the wavelength 391 nm corresponding to the nitrogen ion and nitrogen ion was not confirmed. On the other hand, as shown right down on an enlarged scale, a peak appeared at the wavelength 822 nm corresponding to nitrogen radical and the presence of nitrogen radical was confirmed.

EMBODIMENT 2

As Embodiment 2, film deposition processing was carried out under the following conditions, using an apparatus having the same construction as that of FIG. 1.

 $N_2$ flow rate of $N_2$ feed path 22: 400 sccm
 $N_2$ flow rate of carrier feed path 24: 0.5 ccm
 substrate: c-face sapphire
 substrate temperature 650 degree centigrade
 processing pressure: 40 kPa plusminus 2 kPa
 frequency: 30 kHz

growth time: 30 min

FIG. 6 shows a two-dimensional x-ray diffraction image of a sample obtained by the processing of Embodiment 2. A dot of white color at the center is an image of the c-face sapphire. On its right side, an image showing an epitaxial GaN was confirmed.

Also, a photoluminescence spectrum of a sample obtained in Embodiment 2 was measured. The measurement conditions are as follows.

excitation light source: HeCd laser (325 nm)
filter: 370 nm
laser power: 3 mW
measurement wavelength: 350 nm through 700 nm
measurement temperature: 10 points within a range of from 5 K to 300 K

An optical emission at the band edge of GaN was confirmed as shown in FIG. 7. This optical emission at the band edge of GaN was also confirmed under the condition of room temperature. The lower the measurement temperature became, the sharper the spectrum became.

Moreover, a layer estimated as AlGaN was confirmed at the interface between the c-face sapphire substrate and the GaN layer.

FIG. 8 shows a cathode luminescence spectrum of the sample of Embodiment 2. Beam energy was set to 5 ke V. As shown in FIG. 8(a), a sharp peak appeared in the vicinity of 3.4 eV corresponding to the band edge of GaN under the measurement temperature that was a very low temperature (@ 20 K). When the measurement temperature was brought to a room temperature (@ R.T.), the peak was shifted to the vicinity of 3.7 eV. This is attributable to the effect of optical emission from a substance other than GaN at a depth in the film. It is estimated that this substance is AlGaN, judging from optical emission energy, etc.

The spectrum on the lower side of FIG. 8(b) is an enlargement of the spectrum around the peak under room temperature of FIG. 8(a). A cathode luminescent measurement was carried out with respect to a point of the sample having a smaller film thickness than the measurement point of FIG. 8(a). As a result, the peak was lightly shifted to the high energy side as shown in the upper side spectrum of FIG. 8(b). It can be contemplated that the optical emission of AlGaN becomes more dominant at the point where the film thickness is small.

A cathode luminescent measurement was carried out while the measurement point is fixed to a point where the film thickness is small and the measurement temperature was varied. As a result, it was confirmed that as shown in FIG. 8(c), peak separation occurred between a donor acceptor pair and a donor restraint exciton in AlGaN, as the measurement temperature was lowered.

The cathode luminescence is larger in intrusion depth than the photoluminescence and is suitable for analyzing the AlGaN layer at the depth. On the other hand, the photoluminescence is suitable for analyzing only the GaN layer which is a surface layer and not affected by the AlGaN layer.

The cross section of the above sample was observed by a transmission electron microscope. As a result, a black interface layer, which is supposed to be AlGaN, was observed between the sapphire substrate and the GaN film as shown in FIGS. 9(a) and 9(b). The thickness of the interface layer was in a range of from about 2 nm to 3 nm.

An x-ray diffraction image (FIG. 11) of the above sample was photographed. As shown in FIG. 10, the photographing points were those plural spots a through d on a line astride both sides with an interface between the sapphire substrate and the GaN film sandwiched therebetween. In FIG. 10, the interface between the sapphire substrate and the GaN film is in the form of a right-upward diagonal line. The photographing point b is generally located on this interface. The upper side (the photographing point a side) of the interface is the GaN film and the lower side (the photographing points c, d side) of the interface is the sapphire substrate.

FIG. 11(a) is a diffraction picture of the photographing point a, FIG. 11(b) is a diffraction picture of the photographing point b, FIG. 11(c) is a diffraction photograph of the photographing point c, and FIG. 11(d) is a diffraction photograph of the photographing point d. It was confirmed that at the photographing point a, a single crystal diffraction image was obtained and the GaN was epitaxially grown. The diffraction image of the photographing point b was different from that of the photographing point a. From this, it was confirmed that a crystal different from GaN is generated at the interface layer. It is estimated that this interface crystal is AlGaN.

It was confirmed that at the photographing point c on the side near the interface within the sapphire substrate, an image is slightly more blurred than that at the photographing point d which is deeper than the photographing point c, and the crystallinity is lowered. This is supposedly occurred because the photographing point c was exposed to plasma at the time of forming the GaN film.

[REFERENCE EXPERIMENT 2]

For reference, only nitrogen was introduced into the interelectrode space 11a and nitrogen plasma was generated. This nitrogen plasma was irradiated directly to a central part of the sapphire substrate. Thereafter, a ω rocking curve of the sapphire substrate was measured.

The result is shown in FIG. 12. An oblique line part in FIG. 12 is a region directly exposed to nitrogen plasma at the central part of the substrate, namely, direct plasma region. The left and right outsides of the oblique line part are remote plasma regions where plasma is not directly irradiated. It was confirmed that the half band width was larger at the direct plasma region than that at the remote plasma region and crystallinity was lowered.

It can be contemplated that at the sacrifice of the lowering of crystallinity, Al contained in the sapphire substrate contributes to the generation of AlGaN layer on the interface.

EMBODIMENT 3

In Embodiment 3, the substrate temperature was set to 400 degree centigrade which was lower than those (650 degree centigrade) of the Embodiments 1 and 2 and film deposition processing was carried out. Other processing conditions are as follows.

 processing pressure: 40 kPa plusminus 2 kPa
 $N_2$ flow rate of $N_2$ feed path 22: 400 sccm
 $N_2$ flow rate of carrier feed path 24: 0.5 sccm
 growth time: 30 min
 substrate: c-face sapphire

FIG. 13 shows a pole figure of the sample obtained by the above processing. A 6-times symmetry appeared, although clearness was uneven compared with the case of 650 degree centigrade (FIG. 3). Optical transmission of this sample was measured. As a result, a gentle gradient was observed in the vicinity of the band edge (wavelength 360 nm) of epitaxial GaN as shown in FIG. 14.

By this, it was confirmed that GaN can be epitaxially grown also at the substrate temperature of 400 degree centigrade. It was confirmed that in respect of crystallinity, the substrate temperature is preferably set to about 650 degree centigrade.

Also, a film deposition processing was carried out at a substrate temperature of 350 degree centigrade, with all other conditions remained same as in the case of 400 degree centigrade mentioned above. The substrate after processing was ω-2θ scanned. As a result, a diffraction peak appeared, as shown in FIG. 15, from a 0002 plane of GaN, although it was rather dull compared with the case (FIG. 2) of the substrate temperature of 650 degree centigrade. Also, a two-dimensional x-ray diffraction image was photographed. As a result, an image of the GaN crystal appeared as shown in FIG. 16, although it was not clear compared with the case (FIG. 6) of the substrate temperature of 650 degree centigrade,

By this, it was confirmed that film deposition of GaN can be obtained even if the substrate temperature is about 350 degree centigrade.

[REFERENCE EXPERIMENT 3-1]

For reference, a relation among substrate temperature, application voltage and electric current was measured. The measurement conditions are as follows:

 processing pressure (nitrogen atmospheric pressure): 40 kPa plusminus 2 kPa
 $N_2$ flow rate of $N_2$ feed path 22: 400 sccm
 substrate: c-face sapphire

Two cases of $N_2$ flow rates of the carrier feed path 24 were prepared, 0.5 sccm and 0 sccm. In case where the $N_2$ flow rate is 0. 5 sccm, the process gas introduced into the plasma space 11a is a mixing gas ($N_2$ + TMG) of nitrogen and TMG. In case where the N2 flow rate is 0 sccm, the process gas is only nitrogen.

A lower limit voltage where discharge between the electrodes 13, 14 is in a stable condition and a feed electric current which is fed to the electrode 13 at the time of voltage application were measured for each substrate temperature.

In case where the process gas is only nitrogen, as shown in FIG. 17(a), the higher the substrate temperature was, stable discharge could be obtained at the lower application voltage. On the other hand, as shown in FIG. 17(b), the feed electric current kept a generally constant value irrespective of the substrate temperature.

In case where the process gas is a mixing gas ($N_2$ + TMG) of nitrogen and TMG, as shown in FIG. 17(a), when the substrate temperature was within a range of from room temperature to in the vicinity of 300 degree centigrade, a stable discharge was obtained at a lower application voltage in accordance with increase of temperature, but when the substrate temperature was brought to higher than in the vicinity of 300 degree centigrade, the required voltage became almost constant. Also, as shown in FIG. 17(b), when the substrate temperature was in the vicinity of from 200 to 300 degree centigrade, the feed electric current became minimum, and as the substrate temperature was more increased, the feed electric current was more increased.

Optical emission from the plasma space 11a at the time of discharge was analyzed. The result is shown in FIG. 18.

In case where the process gas is a mixing gas ($N_2$ + TMG) of nitrogen and TMG and the substrate temperature is 650 degree centigrade, generation of Ga radical was confirmed at the wavelengths 403 nm and 417 nm.

On the other hand, in case where the process gas is a mixing gas (N2 + TMG) of nitrogen and TMG and the substrate temperature is a room temperature (@ R.T.), the peaks of the wavelengths 403 nm and 417 nm indicating the generation of Ga radical were hardly confirmed.

Instead, the peaks of the wavelengths 415 nm and 419 nm corresponding to nitrogen carbide (CN) appeared. It is apparent that the nitrogen carbonate is generated by decomposition of TMG, in consideration of the fact that in case where the process gas is only nitrogen, the peaks of the wavelengths 415 nm and 419 nm did not appear.

From the foregoing, it became clear that TMG is decomposed by plasma even under the room temperature but that in order to further radicalizing Ga, a certain degree of temperature is required.

It is contemplated that if the temperature is low, energy of plasma is consumed mostly for the decomposition of TMG, and no energy enough to radicalize Ga is remained. In contrast, if the substrate temperature is increased to a certain degree, decomposition of TMG occurs by that heat and thus, plasma energy can sufficiently be allotted for use of radicalization of Ga.

In case where the process gas is N2 + TMG in FIG. 17(b), the electric current attains an inflexion point in the vicinity of 300 degree centigrade and then goes upward to the right. From the foregoing, it can be estimated that the allotting action of plasma energy takes place in a region where the temperature is higher than in the vicinity of 300 degree centigrade. Thus, in case where TMG is used as a group III material, the lower limit of the substrate temperature is preferably set to about 300 degree centigrade.

TEG, QUG, 1-MPG and the like are thermally decomposable even at a temperature lower by about 100 degree centigrade than TMG. Therefore, in case where they are used as group III material, the lower limit of the substrate temperature can be set in the vicinity of 200 degree centigrade.

[REFERENCE EXPERIMENT 3-2]

The application of voltage between the electrodes 13, 14 was stopped and the process gas (mixing gas of nitrogen and TMG), without being plasmatized, was sprayed onto the substrate. The surface of the substrate was observed. As shown in FIGS. 19(a) and 19(b), a Ga droplet was confirmed at the substrate temperature of 500 degree centigrade or more. As shown in a two-dimensional x-ray diffraction image of FIG. 19(c), generation of GaN was not confirmed even at the substrate temperature of 650 degree centigrade.

As a result, it became clear that if the substrate temperature is brought to a high temperature, TMG can be thermally decomposed but this is not sufficient in order to generate GaN and that in order to generate GaN, activation of Ga such as nitrogen plasma and nitriding means are required.

INDUSTRIAL APPLICABILITY

The present invention can be applied to techniques for manufacturing semiconductor elements such as, for example, optical emission elements and high frequency elements.

**Claims**

1. A method for growing a group III nitride on a substrate, **CHARACTERIZED in that** said method comprises the steps of:

   forming a discharge space by applying an electric field between a pair of electrodes under nitrogen atmosphere in the vicinity of atmospheric pressure; and
   bringing a nitrogen, which is introduced into said discharge space, and a metal compound, which contains a group III metal, into contact with said substrate such that a V/III ratio is within a range of from 10 to 100000.

2. A method for growing a gallium nitride on a substrate, **CHARACTERIZED in that** said method comprises the steps of:

forming a discharge space by applying an electric field between a pair of electrodes under nitrogen atmosphere in the vicinity of atmospheric pressure, and

bringing a nitrogen, which is introduced into said discharge space, and a gallium-containing compound into contact with said substrate such that a V/III ratio is within a range of from 10 to 100000.

3. A method for epitaxially growing a gallium nitride on a c-face or a-face sapphire substrate, **CHARACTERIZED in that** said method comprises the steps of:

forming a discharge space by applying an electric field between a pair of electrodes under nitrogen atmosphere in the vicinity of atmospheric pressure; and

bringing a nitrogen, which is introduced into said discharge space, and a gallium-containing compound into contact with said substrate such that a V/III ratio is within a range of from 10000 to 100000.

4. A method for growing an aluminium gallium nitride on a substrate containing aluminium, **CHARACTERIZED in that** said method comprises the steps of:

forming a discharge space by applying an electric field between a pair of electrodes under nitrogen atmosphere in the vicinity of atmospheric pressure; and

bringing a nitrogen, which is introduced into said discharge space, and a gallium-containing compound into contact with said aluminium-containing substrate such that a V/III ratio is within a range of from 10 to 100000.

5. The film deposition method according to claim 4, wherein said aluminium-containing substrate is a sapphire substrate.

6. The film deposition method according to one of claims 2 through 5, wherein said gallium-containing compound is selected from the group consisting of trimethylgallium, triethylgallium, quinuclidinegallane, and 1-methylpyrrolidinegallane.

7. The film deposition method according to one of claims 1 through 6, **characterized in that** said method further comprises the step of bringing the temperature of said substrate into a range of from 500 degree centigrade to 700 degree centigrade.

8. The film deposition method according to claim 2, 4 or 5, wherein said gallium-containing compound is trimethylgallium, and which further comprises the step of bringing the temperature of said substrate into a range of from 300 degree centigrade to 700 degree centigrade.

9. The film deposition method according to one of claims 3 through 5, wherein said gallium-containing compound is trimethylgallium, and which further comprises the step of bringing the temperature of said substrate into a range of from 400 degree centigrade to 700 degree centigrade.

10. The film deposition method according to claim 2, 4 or 5, wherein said gallium-containing compound is triethylgallium, quinuclidinegallane or 1-methylpyrrolidinegallane, and which further comprises the step of bringing the temperature of said substrate into a range of from 200 degree centigrade to 700 degree centigrade.

11. The film deposition method according to one of claims 3 through 5, wherein said gallium-containing compound is triethylgallium, quinuclidinegallane or 1-methylpyrrolidinegallane, and which further comprises the step of bringing the temperature of said substrate into a range of from 300 degree centigrade to 700 degree centigrade.

12. The film deposition method according to one of claims 1 through 11, wherein said atmospheric pressure is within a range of from 40 kPa to 100 kPa.

[FIG. 1]

[FIG. 2]

[FIG. 3]

[FIG. 4]

Optical Emission Spectroscopy

[FIG. 5]

[FIG. 6]

2D-XRD image

[FIG. 7]

[FIG. 8]

[FIG. 9]

Cross Section TEM Photogragh #01

(a)

Cross Section TEM Photogragh #02

(b)

[FIG. 10]

Cross Section TEM Photogragh #03

[FIG. 11]

(a)

(c)

(b)

(d)

[FIG. 12]

**ω Locking Curve**

[FIG. 13]

Pole Figure

[FIG. 14]

**Optical Transmission**

[FIG. 15]

[FIG. 16]

2D-XRD image

[FIG. 17]

(a)

(b)

[FIG. 18]

[FIG. 19]

(a)

Tsub=500°C

Ga Droplet

(b)

Tsub=650°C

(c)

Tsub=650°C

c-Sapphire

<table>
<tr><td colspan="2">**INTERNATIONAL SEARCH REPORT**</td><td>International application No.<br>PCT/JP2006/315404</td></tr>
</table>

A.  CLASSIFICATION OF SUBJECT MATTER
*H01L21/205*(2006.01)i, *C23C16/34*(2006.01)i, *C23C16/509*(2006.01)i

According to International Patent Classification (IPC) or to both national classification and IPC

B.  FIELDS SEARCHED

Minimum documentation searched (classification system followed by classification symbols)
H01L21/205, C23C16/34, C23C16/509

Documentation searched other than minimum documentation to the extent that such documents are included in the fields searched
Jitsuyo Shinan Koho        1922-1996    Jitsuyo Shinan Toroku Koho    1996-2006
Kokai Jitsuyo Shinan Koho  1971-2006    Toroku Jitsuyo Shinan Koho    1994-2006

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X<br><br>Y | JP 2000-232256 A  (Fuji Xerox Co., Ltd.),<br>22 August, 2000 (22.08.00),<br>Full text; Fig. 1<br>(Family: none) | 1-2,6-8,10,<br>12<br>3-5,9,11 |
| Y | JP 2002-029896 A  (National Institute of<br>Advanced Industrial Science and Technology),<br>29 January, 2002 (29.01.02),<br>Full text; Figs. 1 to 3<br>(Family: none) | 3-5,9,11 |
| A | JP 9-213998 A  (Kyocera Corp.),<br>15 August, 1997 (15.08.97),<br>Full text; Figs. 1 to 4<br>(Family: none) | 1-12 |

☒  Further documents are listed in the continuation of Box C.        ☐  See patent family annex.

| * | Special categories of cited documents: |
|---|---|
| "A" | document defining the general state of the art which is not considered   to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

Date of the actual completion of the international search
11 October, 2006 (11.10.06)

Date of mailing of the international search report
17 October, 2006 (17.10.06)

Name and mailing address of the ISA/
Japanese Patent Office

Facsimile No.

Authorized officer

Telephone No.

Form PCT/ISA/210 (second sheet) (April 2005)

**INTERNATIONAL SEARCH REPORT**

| International application No. |
| --- |
| PCT/JP2006/315404 |

C (Continuation).  DOCUMENTS CONSIDERED TO BE RELEVANT

| Category* | Citation of document, with indication, where appropriate, of the relevant passages | Relevant to claim No. |
| --- | --- | --- |
| A | WO 2003/083950 A1  (ADVANCED TECHNOLOGY MATERIALS, INC.), 09 October, 2003 (09.10.03), Full text; Figs. 1 to 32 & US 2003/0178633 A1    & JP 2005-526384 A | 1-12 |
| A | JP 11-217673 A  (Japan Pionics Co., Ltd.), 10 August, 1999 (10.08.99), Full text; Figs. 1 to 3 & US 6106898 A | 1-12 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H10106958 A

- JP H04164859 A

**Non-patent literature cited in the description**

- Development/Application Trend of Compound Semiconductor. *Electronic Material,* 2004, 18-41
- **ISAMU AKAZAKI.** Advanced Electronics I-21. Group III Nitride Semiconductor. Baifukan, 1999

- *ULVAC TECHNICAL JOURNAL,* 2003, 25